(19) Europäisches Patentamt
European Patent Office
Office européen des brevets

(11) **EP 4 531 520 A1**

(12) **EUROPEAN PATENT APPLICATION**

(43) Date of publication:
**02.04.2025 Bulletin 2025/14**

(21) Application number: **24188612.6**

(22) Date of filing: **15.07.2024**

(51) International Patent Classification (IPC):
**H10H 29/30** (2025.01)

(52) Cooperative Patent Classification (CPC):
**H01L 25/0756; H10H 29/30; H10H 29/8421;
H10H 29/962**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **13.07.2023 PCT/CN2023/107179**

(71) Applicant: **Jade Bird Display (Shanghai) Limited**
**Shanghai 200120 (CN)**

(72) Inventors:
• **GU, Zhichen**
**Shanghai 200120 (CN)**
• **TAN, Weisin**
**Shanghai 200120 (CN)**

(74) Representative: **Finnegan Europe LLP**
**1 London Bridge**
**London SE1 9BG (GB)**

(54) **MICRO LED AND MICRO LED DISPLAY PANEL**

(57) A micro LED includes two or more light emitting mesas which are disposed in a vertical direction from top to bottom; and at least one distributed Bragg reflection (DBR) layer formed between adjacent light emitting mesas, and configured to reflect light emitted by a light emitting mesa of the adjacent light emitting mesas disposed above the DBR layer and pass light emitted by one or more light emitting mesas disposed below the DBR layer.

FIG. 2

EP 4 531 520 A1

**Description**

TECHNICAL FIELD

The present disclosure generally relates to micro LED manufacturing technology, and more particularly, to a micro LED and a micro LED display panel.

BACKGROUND

Inorganic micro pixel light emitting diodes, also referred to as micro light emitting diodes, micro LEDs, or μ-LEDs, become more important since they are used in various applications including self-emissive micro-displays, visible light communications, and optogenetics. The micro LEDs have higher output performance than conventional LEDs because of better strain relaxation, improved light extraction efficiency, and uniform current spreading. Compared with conventional LEDs, the micro LEDs also exhibit several advantages, such as improved thermal effects, faster response rate, larger working temperature range, higher resolution, wider color gamut, higher contrast, lower power consumption, and operability at higher current density.

A micro LED can include multiple light emitting mesas, and each light emitting mesa can be electrically connected to a respective electrode, so that each light emitting mesa can be controlled. Since the multiple light emitting mesas are provided in a vertical direction, light loss may occur within the micro LED, which may degrade light emission efficiency.

SUMMARY OF THE DISCLOSURE

Embodiments of the present disclosure provide a micro LED. The micro LED includes: two or more light emitting mesas which are disposed in a vertical direction from top to bottom; and at least one distributed Bragg reflection (DBR) layer formed between adjacent light emitting mesas, and configured to reflect light emitted by a light emitting mesa of the adjacent light emitting mesas disposed above the DBR layer and pass light emitted by one or more light emitting mesas disposed below the DBR layer.

Embodiments of the present disclosure also provide a micro LED display panel. The micro LED display panel includes an integrated circuit (IC) backplane comprising a bottom pad array, the bottom pad array comprising a plurality of groups of bottom pads; and a micro LED array formed on the IC backplane, the micro LED array including a plurality of the above described micro LEDs. One micro LED of the plurality of micro LEDs is electrically connected with one group of bottom pads of the plurality of groups of bottom pads.

BRIEF DESCRIPTION OF THE DRAWINGS

Embodiments and various aspects of the present disclosure are illustrated in the following detailed description and the accompanying figures. Various features shown in the figures are not drawn to scale.

**FIG. 1** illustrates a structural diagram showing an exemplary dielectric distributed Bragg reflection (DBR) layer, according to some embodiments of the present disclosure.
**FIG. 2** illustrates a structural diagram showing an exemplary micro LED, according to some embodiments of the present disclosure.
**FIG. 3** is a table illustrating exemplary parameters of a first DBR layer and a second DBR layer as shown in **FIG. 2,** according to some embodiments of the present disclosure.
**FIG. 4** is a graph illustrating a relationship between reflectivity rate and wavelength of light for the first DBR layer and the second DBR layer illustrated in **FIG. 3,** according to some embodiments of the present disclosure.
**FIG. 5** illustrates a structural diagram showing a top view of a micro LED display panel, according to some embodiments of the present disclosure.

DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims. Particular aspects of the present disclosure are described in greater detail below. The terms and definitions provided herein control, if in conflict with terms and/or definitions incorporated by reference.

Embodiments of the present disclosure provide a micro LED having improved light emission efficiency. The micro LED includes at least two light emitting mesas provided in a vertical direction, and at least one dielectric distributed Bragg reflection (DBR) layer provided between adjacent light emitting mesas. Each DBR layer includes a first layer and a second layer alternately layered. The DBR layer is configured to reflect light emitted by the light emitting mesa above the DBR layer and have the lights emitted by the light emitting mesa(s) below the DBR layer pass through, so that the light emission efficiency of the micro LED is improved, and each light emitting mesa can have the same size.

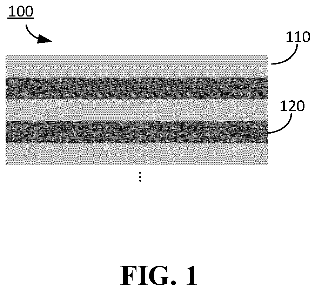

**FIG. 1** illustrates a structural diagram showing an exemplary DBR layer 100, according to some embodiments of the present disclosure. As shown in **FIG. 1,** DBR layer 100 includes a first layer 110 and a second layer 120 which are alternately layered. A refractive index of first layer 110 is denoted by $n_1$, and a thickness of first layer 110 is denoted by $d_1$. A refractive index of second layer 120 is denoted by $n_2$, and a thickness of second layer 120 is denoted by $d_2$. A wavelength to be reflected by DBR layer 100 is denoted by $\lambda_b$. The wavelength $\lambda_b$ can be selected according to a wavelength range to be reflected by DBR layer 100. Different material may have different refractive index. In some embodiments, the thickness $d_1$ of first layer 110 can be obtained by:

$$d_1 = \frac{\lambda_b}{4n_1} \qquad \boldsymbol{Eq.\,(1)}$$

The thickness $d_2$ of second layer 120 can be obtained by:

$$d_2 = \frac{\lambda_b}{4n_2} \qquad \boldsymbol{Eq.\,(2)}$$

A stopband B of DBR layer 100 can be obtained by:

$$B = \frac{2\lambda_b(n_2^2 - n_1^2)}{2\pi n_1 n_2} \qquad \boldsymbol{Eq.\,(3)}$$

In the present disclosure, the stopband $B$ of DBR layer 100 represents a range of wavelength, and the light within the range of wavelength cannot pass through DBR layer 100, while being totally reflected by DBR layer 100. After materials for first layer and second layer are selected, the corresponding refractive indexes $n_1$ and $n_2$ thus determined accordingly. In order to obtain a better reflection efficiency, an appropriate stopband $B$ can be obtained by adjusting the wavelength $\lambda_b$ based on **Eq. (3).** A value of wavelength $\lambda_b$ should be adjusted according a range of a wavelength of light to be reflected, for example, the wavelengths of light emitted by the light emitting mesas above the DBR layer. The stopband $B$ can be set as 100nm, or in some embodiments, the stopband $B$ can be less than 100mn, for example, 80nm, which can be determined according to specific practice. Then, the thickness $d_1$ and the thickness $d_2$ can be determined according to **Eq. (1)** and **Eq. (2)** respectively.

In some embodiment, a total number of first layers 110 and second layers 120 is denoted by N, and N is a positive integer greater than 1. A total thickness of DBR layer 100 is the sum of the thicknesses of N layers of first layers 110 and second layers 120. In some embodiments, when N is an even number, a number of first layer 110 and a number of second layer 120 are the same, i.e., N/2. When N is an odd number, a number of first layer 110 is greater than a number of second layer 120, that is, the number of first layer 110 is (N+1)/2, and the number of second layer 120 is (N-1)/2.

The total reflection efficiency of DBR layer 100 for light having the wavelength $\lambda_b$ is increased as N is increased. To balance the size of a micro LED and the reflection efficiency, the total thickness of DBR layer 100 is preferably not greater than 2μm.

In some embodiments, a material of first layer 110 and a material of second layer 120 are different materials with different refractive indexes. For example, the material of first layer 110 is $SiO_2$ and the material of second layer 120 is $Si_3N_4$.

In some embodiments, amorphous silicon (a-Si) is used in DBR layer 100. For example, one of a material of first layer 110 and a material of second layer 120 is a-Si. In some embodiments, the material of first layer 110 is $SiO_2$ and the material of second layer 120 is a-Si. With the material of one of the first layer 110 and second layer 120 being a-Si material, the total thickness of DBR layer 100 can be thinner, for example, less than 500nm. Since $SiO_2$ may have a better bonding effect with other layers, in this case, the number N of first layer 110 and second layer 120 is an odd number. Therefore, first layer 110 as $SiO_2$ is bonded with other layers of a micro LED.

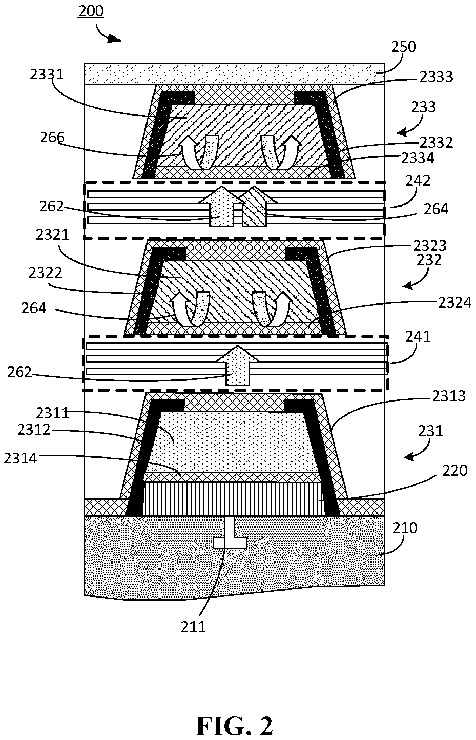

**FIG. 2** illustrates a structural diagram showing an exemplary micro LED 200, according to some embodiments of the present disclosure. As shown in **FIG. 2,** in this example, micro LED 200 includes three light emitting mesas 231, 232, and 233, which are provided on an IC backplane 210 from bottom to top. A first DBR layer 241 is provided between first light emitting mesa 231 and second light emitting mesa 232. A second DBR layer 242 is provided between second light emitting mesa 232 and third light emitting mesa 233. In this example, first light emitting mesa 231 emits red light 262, second light emitting mesa 232 emits green light 264, and third light emitting mesa 233 emits blue light 266. Accordingly, first DBR layer 241 is configured to reflect green light 264 emitted by second light emitting mesa 232 and blue light 266 emitted by third light emitting mesa 233, and have red light 262 emitted by first light emitting mesa 231 pass through. Second DBR layer 242 is configured to reflect blue light 266 emitted by third light emitting mesa 233, and have red light 262 and green light 264 which are emitted by first light emitting mesa 231 or second light emitting mesa 232, respectively, pass through. With this structure, light loss of blue light 266 and green light 262 is reduced, thereby improving the light emission efficiency of micro LED 200. The structures of first DBR layer 241 and second DBR layer 242 are those described above with reference to **FIG. 1,** and further details will be described below.

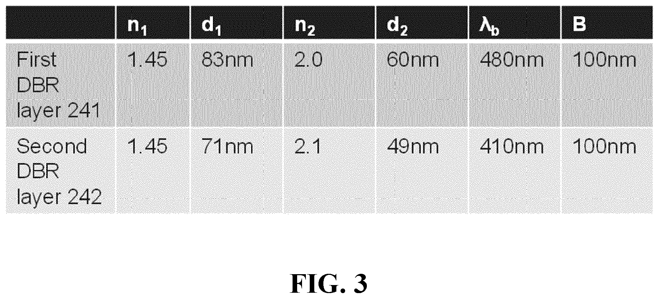

**FIG. 3** is a table illustrating exemplary parameters of first DBR layer 241 and second DBR layer 242, according to some embodiments of the present disclosure. As shown in **FIG. 3,** in this example, based on the materials of first layer and second layer of first DBR layer 241, the refractive index $n_1$ of the first layer of first DBR layer 241 is 1.45, and the refractive index $n_2$ of the second layer of first DBR layer 241 is 2.0. Since first DBR layer 241 is configured to reflect green light 264 (e.g.,

corresponding wavelength is about 510nm -540nm) emitted by second light emitting mesa 232 and blue light 266 (e.g., corresponding wavelength is about 440nm -470nm) emitted by third light emitting mesa 233, the wavelength $\lambda_b$ for first DBR layer 241 is selected to around 480nm-500nm. In order to obtain a stopband $B$ of first DBR layer 241 to be 100nm, based on equation **Eq. (3)** above, the wavelength $\lambda_b$ for first DBR layer 241 is determined to be 480nm. Then, the thickness $d_1$ of the first layer of first DBR layer 241 and the thickness $d_2$ of second layer of first DBR layer 241 can be obtained as 83nm and 60nm, respectively, according to equation **Eq. (1)** and **Eq. (2).**

Similarly, based on the materials of first layer and second layer of second DBR layer 242, the refractive index $n_1$ of the first layer of second DBR layer 242 is 1.45 and the refractive index $n_2$ of the second layer of second DBR layer 242 is 2.1. Since second DBR layer 242 is configured to reflect blue light 266 (e.g., corresponding wavelength is about 440nm - 470nm) emitted by third light emitting mesa 243, the wavelength $\lambda_b$ for second DBR layer 242 is selected to be less than 440nm. In order to obtain a stopband $B$ of second DBR layer 242 to be 100nm, based on equation **Eq. (3)** above, the wavelength $\lambda_b$ for second DBR layer 242 can be determined to be 410nm. Then, the thickness $d_1$ of the first layer of second DBR layer 242 and the thickness $d_2$ of second layer of second DBR layer 242 can be obtained as 71nm and 49nm, respectively, according to equation **Eq. (1)** and **Eq. (2).**

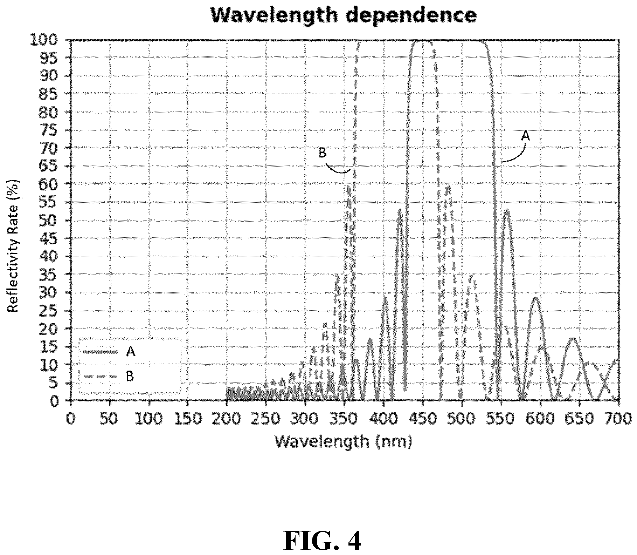

**FIG. 4** is a graphic illustrating a relationship between reflectivity rate and wavelength of light for first DBR layer 241 and second DBR layer 242, according to some embodiments of the present disclosure. In this example, N is equal to 15 as the total number of layers of first DBR layer 241 and second DBR layer 242. As shown in **FIG. 4,** the X-axis represents a wavelength of light, and the Y-axis represents a reflectivity rate corresponding to the wavelength. Curves A and B represent relationships between the reflectivity rate and the wavelength of first DBR layer 241 and second DBR layer 242, respectively. When a reflectivity rate is to 100%, lights with the corresponding wavelength can be totally reflected by a corresponding DBR layer, and when a reflectivity rate is to 0, light with the corresponding wavelength can totally pass through the corresponding DBR layer. Referring to **FIG. 4,** a stopband (e.g., a wavelength range corresponding to reflectivity rate being about 100%) of first DBR layer 241 is 100nm, in a wavelength range of 430nm to 530nm. A reflectivity rate for wavelength greater than 600nm, which corresponds to red light, is relatively low, for example, less than 30%. That is, first DBR layer 241 can reflect most green lights and blue lights, and have red light pass through. Similarly, a stopband of second DBR layer 242 is 100nm, in a wavelength range of 360nm to 460nm. A reflectivity rate for wavelength greater than 500nm, which corresponds to green light and red light, is relatively low, for example, less than 35%. That is, second DBR layer 242 can reflect most blue light, and have red light and green light pass through.

Referring with **FIG. 3** and **FIG. 4,** in this example, for N is equal to 15, a total thickness of first DBR layer 241 is 1084nm, and a total thickness of second DBR layer 242 is 911nm.

Since first DBR layer 241 and second DBR layer 242 can improve the light emitting efficiency of the light emitting mesas 231, 232, and 233, the same mesa size for each light emitting mesa can be achieved.

As it can be understood, in some embodiments, first light emitting mesa may emits red light, second light emitting mesa emits blue light, and third light emitting mesa emits green light. Accordingly, first DBR layer is configured to reflect blue light emitted by second light emitting mesa and green light emitted by third light emitting mesa, and have red light emitted by first light emitting mesa pass through. Second DBR layer is configured to reflect green light emitted by third light emitting mesa, and have red light and blue light which are emitted by first light emitting mesa or second light emitting mesa, respectively, pass through. Accordingly, parameters of respective first DBR layer and second DBR layer can be obtained according to **Eq. (1)** and **Eq. (2)** based on the corresponding wavelength to be reflected.

Referring back to **FIG. 2,** in some embodiments, first light emitting mesa 231 includes a first mesa structure 2311, a first passivate layer 2312 formed on a sidewall of first mesa structure 2311, and a first top transparent layer 2313 formed on a surface of first passivate layer 2312 and covering a top surface of first mesa structure 2311. First mesa structure 2311 is configured to emit light. For example, first mesa structure 2311 may further include a first semiconductor layer, a light emitting layer provided on the first semiconductor layer, and a second semiconductor layer provided on the light emitting layer. First top transparent layer 2313 is electrically connected with the top surface of first mesa structure 2311. In some embodiments, first light emitting mesa 231 further includes a first bottom transparent layer 2314 provided on a bottom of first mesa structure 2311 and configured to bond with IC backplane 210 by a bonding layer 220. In some embodiments, first passivate layer 2312 is further formed on sidewalls of bonding layer 220 and first bottom transparent layer 2314.

In some embodiments, IC backplane 210 may include a group of three bottom pads to electrically connect with each light emitting mesa, respectively. For example, a first bottom pad 211 is electrically connected to bonding layer 220 to further connect with first light emitting mesa 231. In some embodiments, a conductive structure (not shown) is further provided to electively connect a bottom of second light emitting mesa 232 and a bottom of third light emitting mesa 233 to a second bottom pad (not shown) and a third bottom pad (not shown) of IC backplane 210, respectively.

In some embodiments, second light emitting mesa 232 includes a second mesa structure 2321, a second passivate layer 2322 formed on a sidewall of second mesa structure 2321, and a second top transparent layer 2323 formed on a surface of second passivate layer 2322 and covering a top surface of second mesa structure 2321. Second mesa structure 2321 is configured to emit light. For example, second mesa structure 2321 may further include include a first semiconductor layer, a light emitting layer provided on the first semiconductor layer, and a second semiconductor layer provided on the light emitting layer. Second top transparent layer 2323 is electrically connected with the top surface of second mesa structure 2321. In some embodiments, second light emitting mesa 232 further includes a second bottom transparent layer 2324 provided on a bottom of second mesa structure 2321 and configured to further electrically connect the bottom of second mesa structure 2321 to the second bottom pad through the conductive structure.

In some embodiments, third light emitting mesa 233 includes a third mesa structure 2331, a third passivate layer 2332 formed on a sidewall of third mesa structure 2321, and a third top transparent layer 2333 formed on a surface of third passivate layer 2332 and covering a top surface of third mesa structure 2331. Third mesa structure 2331 is configured to emit light. For example, third mesa structure 2331 may further include a first semiconductor layer, a light emitting layer provided on the first semiconductor layer, and a second semiconductor layer provided on the light emitting layer. Third top transparent layer 2333 is electrically connected with the top surface of third mesa structure 2331. In some embodiments, third light emitting mesa 233 further includes a third bottom transparent layer 2334 provided on a bottom of third mesa structure 2331 and configured to further electrically connect the bottom of third mesa structure 2331 to the third bottom pad through the conductive structure.

In some embodiments, each of first top transparent layer 2313, first bottom transparent layer 2314, second top transparent layer 2323, second bottom transparent layer 2324, third top transparent layer 2333, and third bottom transparent layer 2334 is a TCO (transparent conductive oxide) thin film, for example, an ITO (Indium Tin Oxide) film, an AZO (Antimony doped Zinc Oxide) film, an ATO (Antimony doped Tin Oxide) film, an FTO (Fluorine doped Tin Oxide) film, and the like.

In some embodiments, micro LED 200 further includes a top conductive layer 250 formed on third light emitting mesa 233. In some embodiments, top conductive layer 250 is a TCO (transparent conductive oxide) thin film, for example, an ITO (Indium Tin Oxide) film, an AZO (Antimony doped Zinc Oxide) film, an ATO (Antimony doped Tin Oxide) film, an FTO (Fluorine doped Tin Oxide) film, and the like.

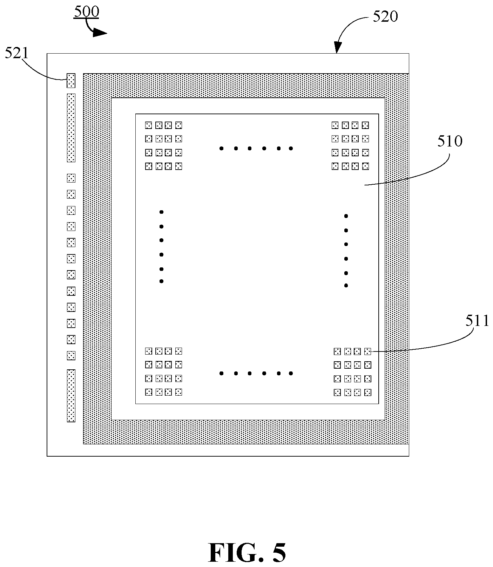

FIG. 5 illustrates a structural diagram showing a top view of a micro LED display panel 500, according to some embodiments of the present disclosure. Referring to FIG. 5, micro LED display panel 500 includes a micro LED array 510 and an IC (integrated circuit) backplane 520. Micro LED array 510 is located on IC backplane 520 to form an image display area of micro LED display panel 500. The rest of the area on IC backplane 520 not covered by micro LED array 510 is formed as a non-functional area. IC backplane 520 is formed at the back surface of micro LED array 510 with a part extending outside of, i.e., not covered by, micro LED array 510. Micro LED array 510 includes a plurality of micro LEDs 511 provided in an array. IC backplane 520 is configured to control the plurality of micro LEDs 511. IC backplane 520 may include a bottom pad array (not shown) corresponding to micro LED array 510. The bottom pad array includes a plurality of groups of bottom pads (for example, a group of three bottom pads including bottom pad 211 in FIG. 2), and one group of bottom pads corresponds to one micro LED 511. One micro LED of the plurality of micro LEDs is electrically connected with one bottom pad group of the plurality of the groups of bottom pads.

In some embodiments, a top conductive layer (for example, top conductive layer 250 in FIG. 2) of the micro LED is interconnected with each of the plurality of micro LEDs. That is, the top conductive layer is continuously formed on a top of micro LED array 510, and connected with every micro LED 511.

In some embodiments, IC backplane 520 further includes a top connected pad 521. The top conductive layer is connected with top connected pad 521, and further may connect to an external circuit.

Each micro LED herein (e.g., micro LED 200) has a very small volume. The micro LED can be applied in a micro LED display panel. The light emitting area of the micro LED display panel, e.g., micro LED display panel 500, is very small, such as 1mm×1mm, 3mm×5mm, etc. In some embodiments, the light emitting area is the area of the micro LED array in the micro LED display panel. The micro LED display panel includes one or more micro LEDs that form a pixel array in which the micro LEDs are pixels, such as a 1600×1200, 680x480, or 1920×1080-pixel array. The diameter of each micro LED is in the range of about 200nm to $2\mu m$. An IC backplane, e.g., IC backplane 520, is formed at the back surface of micro LED array 510 and is electrically connected with micro LED array 510. IC backplane 520 acquires signals such as image data from outside via signal lines to control corresponding micro LEDs 511 to emit light or not.

It is understood by those skilled in the art that the micro LED display panel is not limited by the structure described above, and may include greater or fewer components than those illustrated, or some components may be combined, or a different component may be utilized.

It should be noted that relational terms herein such as "first" and "second" are used only to differentiate an entity or operation from another entity or operation, and do not require or imply any actual relationship or sequence between these entities or operations. Moreover, the words "comprising," "having," "containing," and "including," and other similar forms are intended to be equivalent in meaning and be open ended in that an item or items following any one of these words is not meant to be an exhaustive listing of such item or items, or meant to be limited to only the listed item or items.

As used herein, unless specifically stated otherwise, the term "or" encompasses all possible combinations, except where infeasible. For example, if it is stated that a database may include A or B, then, unless specifically stated otherwise or infeasible, the database may include A, or B, or A and B. As a second example, if it is stated that a database may include A, B, or C, then, unless specifically stated otherwise or infeasible, the database may include A, or B, or C, or A and B, or A and C, or B and C, or A and B and C.

In the foregoing specification, embodiments have been described with reference to numerous specific details that can vary from implementation to implementation. Certain adaptations and modifications of the described embodiments can be made. Other embodiments can be apparent to those skilled in the art from consideration of the specification and practice of the invention disclosed herein. It is intended that the specification and examples be considered as exemplary only, with a true scope and spirit of the invention being indicated by the following claims. It is also intended that the sequence of steps shown in figures are only for illustrative purposes and are not intended to be limited to any particular sequence of steps. As such, those skilled in the art can appreciate that these steps can be performed in a different order while implementing the same method.

In the drawings and specification, there have been disclosed exemplary embodiments. However, many variations and modifications can be made to these embodiments. Accordingly, although specific terms are employed, they are used in a generic and descriptive sense only and not for purposes of limitation.

**Claims**

1. A micro LED, comprising:

    two or more light emitting mesas which are disposed in a vertical direction from top to bottom; and
    at least one distributed Bragg reflection "DBR" layer formed between adjacent light emitting mesas, and configured to reflect light emitted by a light emitting mesa of the adjacent light emitting mesas disposed above the DBR layer and pass light emitted by one or more light emitting mesas disposed below the DBR layer.

2. The micro LED according to claim 1, wherein the DBR layer comprises a plurality of first layers and a plurality of second layers, the plurality of first layers and the plurality of second layers being alternately layered, and a first refractive index of the plurality of first layers and a second refractive index of the plurality of second layers are different.

3. The micro LED according to claim 2, wherein a first thickness of one of the plurality of first layers is determined based on the first refractive index and a wavelength; and
   a second thickness of one of the plurality of second layers is determined based on the second refractive index and the wavelength, wherein the wavelength is in a wavelength range to be reflected by the DBR layer.

4. The micro LED according to claim 3, wherein the first thickness is obtained by

$$d_1 = \frac{\lambda_b}{4n_1}$$

   and the second thickness is obtained by:

$$d_2 = \frac{\lambda_b}{4n_2}$$

   wherein $d_1$ represents the first thickness, $n_1$ represents the first refractive index, $d_2$ represents the second thickness, $n_2$ represents the second refractive index, $\lambda_b$ represents the wavelength.

5. The micro LED according to claim 4, wherein the wavelength is adjustable to obtain a stopband $B$ of the DBR layer based on a relationship of
$$B = \frac{2\lambda_b\left(n_2^2 - n_1^2\right)}{2\pi n_1 n_2}.$$

6. The micro LED according to claim 5, wherein the stopband is 100nm.

7. The micro LED according to any one of claims 2 to 6, wherein one of a first material of the first layer and a second material of the second layer is amorphous silicon (a-Si).

8. The micro LED according to claim 7, wherein the first material of the first layer is $SiO_2$ and the second material of the second layer is a-Si.

9. The micro LED according to any one of claims 2 to 6, wherein the first material and the second material are $SiO_2$ and $Si_3N_4$, respectively.

10. The micro LED according to any one of claims 1 to 9, wherein the two or more light emitting mesas comprise:

a first light emitting mesa configured to emit red light,

a second light emitting mesa configured to emit green light and provided above the first light emitting mesa; and

a third light emitting mesa configured to emit blue light and provided above the second light emitting mesa;

wherein the at least one DBR layer comprises:

a first DBR layer provided between the first light emitting mesa and the second light emitting mesa, and configured to pass the red light and reflect the green light and the blue light; and

a second DBR layer provided between the second light emitting mesa and the third light emitting mesa, and configured to reflect the blue light and pass the red light and the green light.

11. The micro LED according to any one of claims 1 to 9, wherein the two or more light emitting mesas comprise:

a first light emitting mesa configured to emit red light,

a second light emitting mesa configured to emit blue light and provided above the first light emitting mesa; and

a third light emitting mesa configured to emit green light and provided above the second light emitting mesa;

wherein the at least one DBR layer comprises:

a first DBR layer provided between the first light emitting mesa and the second light emitting mesa, and configured to pass the red light and reflect the blue light and the green light; and

a second DBR layer provided between the second light emitting mesa and the third light emitting mesa, and configured to reflect the green light and pass the red light and the blue light.

12. The micro LED according to claim 1, wherein each one of the two or more light emitting mesas comprises:

a mesa structure configured to emit light;

a passivate layer formed on a sidewall of the mesa structure;

a top transparent layer formed on a surface of the passivate layer and covering a top surface of the mesa structure, wherein the top transparent layer is electrically connected with the top surface of the mesa structure; and

a bottom transparent layer formed on a bottom of the mesa structure and electrically connected with the bottom of the mesa structure.

13. A micro LED display panel comprises:

an integrated circuit (IC) backplane comprising a bottom pad array, the bottom pad array comprising a plurality of groups of bottom pads; and

a micro LED array formed on the IC backplane, the micro LED array comprising a plurality of micro LEDs according to any one of claims 1 to 12;

wherein one micro LED of the plurality of micro LEDs is electrically connected with one group of bottom pads of the plurality of groups of bottom pads.

14. The micro LED display panel according to claim 13, wherein the micro LED further includes a top conductive layer formed on a top of the micro LED, and respective top conductive layers of the plurality of micro LEDs are interconnected.

15. The micro LED display panel according to claim 14, wherein the IC backplane further comprises a top connected pad, and the top conductive layer is connected with the top connected pad of the IC backplane.

**FIG. 1**

**FIG. 2**

| | $n_1$ | $d_1$ | $n_2$ | $d_2$ | $\lambda_b$ | B |
|---|---|---|---|---|---|---|
| First DBR layer 241 | 1.45 | 83nm | 2.0 | 60nm | 480nm | 100nm |
| Second DBR layer 242 | 1.45 | 71nm | 2.1 | 49nm | 410nm | 100nm |

## FIG. 3

**Wavelength dependence**

FIG. 4

**FIG. 5**

Europäisches
Patentamt

European
Patent Office

Office européen
des brevets

# EUROPEAN SEARCH REPORT

Application Number

EP 24 18 8612

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/085036 A1 (MEZOUARI SAMIR [GB] ET AL) 16 March 2023 (2023-03-16) | 1-6,10, 13 | INV. H01L25/075 |
| Y | * paragraphs [0203] - [0222]; figure 3 * | 7-9 | |
| | ----- | | ADD. |
| X | US 2021/384181 A1 (XU QUNCHAO [CN] ET AL) 9 December 2021 (2021-12-09) | 1-5,10, 12-15 | H01L33/10 H01L33/46 |
| Y | * paragraphs [0227] - [0238]; figure 2 * | 7-9 | |
| | ----- | | |
| X | US 2019/165037 A1 (CHAE JONG HYEON [KR] ET AL) 30 May 2019 (2019-05-30) | 1-6,10, 11,13-15 | |
| Y | * figures 1-16 * <br> * figures 39-43 * <br> * figures 59A-68B * | 7-9 | |
| | ----- | | |
| X | EP 3 648 164 A1 (LG ELECTRONICS INC [KR]) 6 May 2020 (2020-05-06) | 1-6,10, 12-15 | |
| Y | * paragraph [0111]; figures 10, 11, 13 * | 7-9 | |
| | ----- | | |
| Y | CHO MINKYU ET AL: "Amorphous Si/SiO2distributed Bragg reflectors with transfer printed single-crystalline Si nanomembranes", JOURNAL OF VACUUM SCIENCE, AMERICAN INSTITUTE OF PHYSICS, 2 HUNTINGTON QUADRANGLE, MELVILLE, NY 11747, vol. 34, no. 4, 12 April 2016 (2016-04-12) , XP012211310, ISSN: 2166-2746, DOI: 10.1116/1.4945998 [retrieved on 1901-01-01] * abstract * | 7,8 | TECHNICAL FIELDS SEARCHED (IPC) <br><br> H01L |
| | ----- | | |
| Y | US 2006/140239 A1 (NEGRO LUCA D [US] ET AL) 29 June 2006 (2006-06-29) * paragraph [0009] * | 9 | |
| | ----- | | |

The present search report has been drawn up for all claims

| Place of search | Date of completion of the search | Examiner |
|---|---|---|
| The Hague | 18 December 2024 | Dehestru, Bastien |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
 
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 18 8612

This annex lists the patent family members relating to the patent documents cited in the above-mentioned European search report.
The members are as contained in the European Patent Office EDP file on
The European Patent Office is in no way liable for these particulars which are merely given for the purpose of information.

18-12-2024

| Patent document cited in search report | | Publication date | Patent family member(s) | | Publication date |
|---|---|---|---|---|---|
| US 2023085036 | A1 | 16-03-2023 | CN | 115066751 A | 16-09-2022 |
| | | | EP | 4088317 A1 | 16-11-2022 |
| | | | GB | 2592017 A | 18-08-2021 |
| | | | JP | 2023512589 A | 27-03-2023 |
| | | | KR | 20220138863 A | 13-10-2022 |
| | | | TW | 202147563 A | 16-12-2021 |
| | | | US | 2023085036 A1 | 16-03-2023 |
| | | | WO | 2021161005 A1 | 19-08-2021 |
| US 2021384181 | A1 | 09-12-2021 | AU | 2021283948 A1 | 09-02-2023 |
| | | | CN | 115836341 A | 21-03-2023 |
| | | | DE | 21817305 T1 | 06-07-2023 |
| | | | EP | 4162481 A1 | 12-04-2023 |
| | | | JP | 2023528829 A | 06-07-2023 |
| | | | KR | 20230022942 A | 16-02-2023 |
| | | | TW | 202205688 A | 01-02-2022 |
| | | | US | 2021384181 A1 | 09-12-2021 |
| | | | WO | 2021247887 A1 | 09-12-2021 |
| US 2019165037 | A1 | 30-05-2019 | BR | 112020010688 A2 | 10-11-2020 |
| | | | CN | 110870065 A | 06-03-2020 |
| | | | CN | 111244078 A | 05-06-2020 |
| | | | EP | 3718138 A1 | 07-10-2020 |
| | | | JP | 7206276 B2 | 17-01-2023 |
| | | | JP | 7568705 B2 | 16-10-2024 |
| | | | JP | 2021504753 A | 15-02-2021 |
| | | | JP | 2023052124 A | 11-04-2023 |
| | | | KR | 20200087168 A | 20-07-2020 |
| | | | US | 2019165037 A1 | 30-05-2019 |
| | | | US | 2020303451 A1 | 24-09-2020 |
| | | | US | 2022130898 A1 | 28-04-2022 |
| | | | US | 2022392950 A1 | 08-12-2022 |
| | | | US | 2023261033 A1 | 17-08-2023 |
| | | | US | 2024297206 A1 | 05-09-2024 |
| | | | US | 2024363675 A1 | 31-10-2024 |
| | | | WO | 2019103568 A1 | 31-05-2019 |
| EP 3648164 | A1 | 06-05-2020 | CN | 110809824 A | 18-02-2020 |
| | | | EP | 3648164 A1 | 06-05-2020 |
| | | | KR | 20190003162 A | 09-01-2019 |
| | | | US | 2020219858 A1 | 09-07-2020 |
| | | | US | 2022231000 A1 | 21-07-2022 |
| | | | WO | 2019004508 A1 | 03-01-2019 |
| US 2006140239 | A1 | 29-06-2006 | US | 2005255619 A1 | 17-11-2005 |
| | | | US | 2006140239 A1 | 29-06-2006 |

EPO FORM P0459

For more details about this annex : see Official Journal of the European Patent Office, No. 12/82

page 1 of 2

## ANNEX TO THE EUROPEAN SEARCH REPORT
## ON EUROPEAN PATENT APPLICATION NO.

EP 24 18 8612

This annex lists the patent family members relating to the patent documents cited in the above-mentioned European search report.
The members are as contained in the European Patent Office EDP file on
The European Patent Office is in no way liable for these particulars which are merely given for the purpose of information.

18-12-2024

| Patent document cited in search report | Publication date | Patent family member(s) | Publication date |
|---|---|---|---|
| | | WO 2005104147 A2 | 03-11-2005 |
| | | WO 2005104317 A1 | 03-11-2005 |

EPO FORM P0459

For more details about this annex : see Official Journal of the European Patent Office, No. 12/82

page 2 of 2